Europäisches Patentamt

European Patent Office

Office européen des brevets

(11) Numéro de publication: **0 349 028**
**A2**

## (12) DEMANDE DE BREVET EUROPEEN

(21) Numéro de dépôt: **89201510.8**

(22) Date de dépôt: **12.06.89**

(51) Int. Cl.4: **H03K 3/356**

(30) Priorité: **17.06.88 FR 8808147**

(43) Date de publication de la demande:
**03.01.90 Bulletin 90/01**

(84) Etats contractants désignés:
**CH DE FR GB IT LI NL**

(71) Demandeur: **LABORATOIRES
D'ELECTRONIQUE ET DE PHYSIQUE
APPLIQUEE L.E.P.
3, Avenue Descartes
F-94450 Limeil-Brévannes(FR)**

(84) **FR**

Demandeur: **N.V. Philips'
Gloeilampenfabrieken
Groenewoudseweg 1
NL-5621 BA Eindhoven(NL)**

(84) **CH DE GB IT LI NL**

(72) Inventeur: **Ducourant, Thierry
Société Civile S.P.I.D. 209 rue de l'Université
F-75007 Paris(FR)**

(74) Mandataire: **Landousy, Christian et al
Société Civile S.P.I.D. 209, Rue de
l'Université
F-75007 Paris(FR)**

(54) **Circuit semiconducteur intégré comprenant une paire différentielle de transistors à effet de champ.**

(57) Circuit semiconducteur intégré comprenant un étage différentiel formé de transistors à effet de champ (10,11) présentant des sorties (34,35) couplées aux entrées d'un sous-circuit (12,13) pour contrôler ledit sous-circuit, et comprenant un circuit de charge ($R_4$,$R_3$) de l'étage différentiel, caractérisé en ce qu'il comprend aussi des moyens de lissage pour lisser les fluctuations de l'impédance de sortie de ladite partie différentielle durant la commutation.

FIG. 1

EP 0 349 028 A2

## CIRCUIT SEMICONDUCTEUR INTEGRE COMPRENANT UNE PAIRE DIFFERENTIELLE DE TRANSISTORS A EFFET DE CHAMP

L'invention concerne un circuit semiconducteur intégré comprenant une paire différentielle de transistors à effet de champ qui sont respectivement couplés à une tension d'alimentation à travers une charge, le noeud entre chaque transistor à effet de champ et sa charge respective étant couplé à un sous-circuit pour contrôler ledit sous-circuit.

L'invention trouve son application par exemple dans un circuit comparateur à verrouillage, pour comparer une tension d'entrée analogique $V_{IN}$, à une tension de référence analogique $V_{REF}$ formé de transistors à effet de champ.

L'invention trouve aussi son application par exemple dans un circuit comparateur synchronisé comprenant au moins deux de ces circuits montés en parallèle.

Un exemple de l'invention trouve son application dans la réalisation d'un convertisseur analogique-numérique dit parallèle dans lequel le signal d'entrée analogique est amené aux entrées de plusieurs circuits comparateurs parallèles pour obtenir un signal de sortie numérique, circuits dans lesquels cette tension d'entrée est comparée avec une tension de référence qui est différente pour chaque circuit comparateur. Les signaux de sortie des circuits comparateurs sont convertis en un signal de sortie numérique à l'aide d'un dispositif de décodage. Le comparateur synchronisé utilisé dans de tels comparateurs analogiques parallèles présente en général une structure comme décrite dans le préambule.

Un tel circuit est connu entre autres de la demande de brevet européen N° 85 201742.5.

Cette demande décrit un comparateur de tensions, réalisé à l'aide de transistors dotés chacun d'une borne de commande, d'une première borne principale et d'une seconde borne principale, ce comparateur comprenant :

- un étage d'acquisition servant à comparer une tension d'entrée analogique ($V_{IN}$) à une tension de référence analogique ($V_{REF}$) et à fournir le résultat de la comparaison sous forme d'un signal intermédiaire ($V_M$) et de son complémentaire ( $\overline{V_M}$), cet étage incluant deux transistors formant une première paire différentielle, la tension d'entrée ($V_{IN}$) et la tension de référence ($V_{REF}$) étant appliquées respectivement sur les bornes de commande de ces transistors dont les premières bornes principales présentent un point de connexion servant à amener un courant de réglage, et dont les secondes bornes principales sont couplées chacune par l'intermédiaire d'une charge résistive à une première borne d'alimentation continue ($V_{DD}$) et fournissent respectivement le signal intermédiaire et son complémentaire ;

- un étage mémoire couplé à l'étage d'acquisition, servant à produire les états logiques déterminés par les signaux issus des étages d'acquisition, cet étage mémoire incluant deux transistors formant une deuxième paire différentielle montée en bascule bistable, les signaux issus de chacune des branches de l'étage d'acquisition étant appliqués respectivement sur les bornes de commande de ces transistors dont les premières bornes principales présentent un point de connexion et dont les secondes bornes principales sont couplées en croix aux bornes de commande des transistors de la deuxième paire, ces derniers points de connexion constituant les sorties de cet étage mémoire.

Dans le circuit connu :

- le point de connexion de la première paire différentielle est couplé à une deuxième borne d'alimentation continue négative $V_{SS}$ par l'intermédiaire d'un transistor source de courant ;

- le point de connexion de la deuxième paire différentielle est porté directement au potentiel de la seconde borne d'alimentation continue $V_{SS}$ ;

- la deuxième paire différentielle est couplée à une troisième paire différentielle incluant deux transistors montés en parallèle sur les transistors de la deuxième paire différentielle et dont les bornes de commande recoivent un signal d'horloge (C).

En outre :

les secondes bornes principales de la première paire différentielle, sont couplées respectivement aux bornes de commande de la deuxième paire différentielle chacune par l'intermédiaire d'une résistance de couplage, et le transistor source de courant de la première paire différentielle peut être commandé par le signal d'horloge dans un mode de réalisation, ou par une troisième tension d'alimentation continue dans un second mode de réalisation.

Ce circuit connu présente un certain nombre d'inconvénients.

Tout d'abord la conductance de sortie de chacun des transistors de l'étage d'acquisition, qui sont des transistors à effet de champ du type MESFET, change en fonction de la fréquence.

Il en résulte que l'impédance vue du côté drain de ces MESFETS peut varier jusqu'à un facteur 3. Ainsi cette impédance devient trois fois plus faible en hautes fréquences qu'en basses fréquences.

Lors d'une transition, la tension de référence $V_{REF}$ ne changeant pas, et la tension d'entrée $V_{IN}$ subissant une variation extrêmement rapide, le courant dérivé du côté drain du transistor qui reçoit la tension d'entrée $V_{IN}$ passe par une valeur transitoire forte correspondant à la conductance alors devenue forte de ce transistor, due à cette transition rapide.

Puis le courant dérivé du côté drain du transistor qui reçoit cette tension d'entrée $V_{IN}$ se relaxe à une valeur plus faible qui correspond à la valeur statique de la conductance de sortie de ce transistor.

Au niveau électrique, ceci se traduit, lors des commutations rapides de $V_{IN}$ autour de $V_{REF}$, en des traînages basse fréquence de la tension différentielle de sortie. En pourcentage, ce traînage peut atteindre 10 % de la dynamique de sortie. Par exemple si avant une commutation, dans un état où $V_{IN} \# V_{REF}$, la différence de tension entre la sortie et la sortie complémentaire est 1 voit, après commutation rapide lorsque $V_{IN}$ est devenu égal à $V_{REF}$, la sortie et la sortie complémentaire gardent une différence de niveau de l'ordre de 0,1 V pendant un temps non négligeable avant de prendre la même valeur.

La présente invention propose un circuit dans lequel cet effet de traînage devient négligeable.

Selon l'invention ce but est atteint au moyen d'un circuit tel que décrit dans le préambule et en outre caractérisé en ce qu'il comprend des moyens de lissage pour lisser les fluctuations de l'impédance de sortie de ladite partie différentielle durant la commutation.

Dans une mise en oeuvre de l'invention, ce circuit est caractérisé en ce que les moyens de lissage comprennent, entre chacun desdits transistors à effet de champ et sa charge respective, un transistor monté en cascode polarisé à une tension prédéterminée, le noeud entre chaque transistor monté en cascode et la charge associée étant couplés avec le sous-circuit.

Cet étage cascode isole l'étage différentiel de ses charges dans lesquelles s'opère un gain en tension. De cette façon on obtient qu'il n'existe plus de gain en tension au niveau des sorties de l'étage différentiel, et on minimise les conséquences des variations de la conductance de sortie de cet étage en fonction de la fréquence.

Dans une mise en oeuvre de l'invention ce circuit est en outre caractérisé en ce que les moyens de lissage comprennent un moyen de contre-réaction contrôlant chacun des transistors à effet de champ de la paire différentielle au moyen d'un signal fonction de la tension entre les électrodes de l'autre transistor à effet de champ de la paire différentielle.

Cette contre-réaction stabilise les tensions de sortie de l'étage différentiel.

Dans une forme de réalisation préférentielle, ce circuit est caractérisé en ce que chaque transistor à effet de champ de la paire différentielle de transistors a une première électrode de grille et une seconde électrode de grille pour recevoir un signal d'entrée, et pour la connexion à l'autre transistor à effet de champ respectivement.

Dans cette forme de réalisation le circuit est particulièrement compact donc favorable à l'intégration à haute densité.

Le circuit de l'étage différentiel, du sous-circuit, des charges agencées selon l'invention et munies des moyens de l'invention est alors particulièrement favorable à constituer l'étage d'acquisition d'un comparateur synchronisé pour comparer une tension d'entrée analogique $V_{IN}$ à une tension de référence analogique $V_{REF}$, ces entrées étant appliquées aux entrées de l'étage différentiel, ce comparateur comportant en outre un étage mémoire relié à l'étage d'acquisition par des charges.

Dans ces conditions, non seulement les conséquences des variations de la conductance de sortie de l'étage d'acquisition en fonction de la fréquence sont minimisées, car l'étage cascode isole l'étage d'acquisition des charges de l'étage mémoire dans lesquelles s'opère un gain en tension, mais encore l'étage cascode permet d'élargir la bande passante et d'augmenter le gain de tout le comparateur.

L'invention sera mieux comprise au moyen de la description suivante illustrée par les figures annexées dont :

- la figure 1 qui représente un circuit comparateur selon l'invention ;
- la figure 2 qui représente un système de deux circuits comparateurs selon l'invention
- la figure 3 qui présente un exemple de séquencement des signaux dans le circuit de la figure 1.
- la figure 4 qui représente le séquencement des signaux dans le circuit de la figure 2b.
- la figure 5 qui représente un convertisseur analogique-numérique réalisé à l'aide d'un circuit selon l'invention.

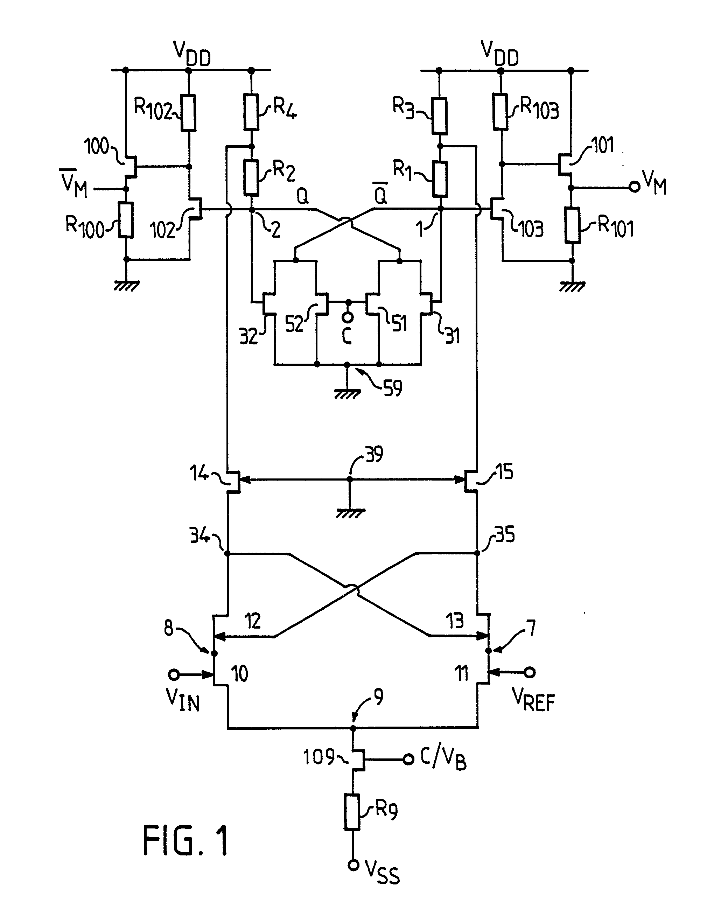

La figure 1 représente un comparateur synchronisé qui est par exemple avantageusement réalisé à l'aide de transistors à effet de champ à enrichissement, par exemple en arséniure de gallium, transistors dont la tension de pincement $V_T > 0$ entraîne qu'ils sont normalement pincés en l'absence de signal.

Ce comparateur synchronisé comporte d'abord un étage d'acquisition formé de deux transistors 10 et 11, couplés par les sources et dont les grilles reçoivent respectivement la tension d'entrée analogique $V_{IN}$ et la tension de référence analogique $V_{REF}$.

3

Les sources des transistors 10 et 11 couplées au point de connexion 9 sont mises à l'alimentation négative $V_{SS}$ par l'intermédiaire d'un transistor source de courant 109, commandé par le signal d'horloge C, dont la source est reliée à la masse à travers une résistance R9.

Ce comparateur synchronisé comporte aussi un étage mémoire formé de deux transistors 32 et 31 couplés par leurs sources au point de connexion 59. Ce point de connexion est directement porté au potentiel de la masse.

La commande de cet étage mémoire est assurée par deux transistors 52 et 51 respectivement montés en parallèle sur les transistors 32 et 31, et commandés par un signal de contrôle ou d'horloge C.

Dans ces conditions, lorsque l'étage d'acquisition est mis en fonctionnement, l'étage mémoire se voit imposer directement l'état 0. Or on sait que, pour obtenir un bon effet d'un tel étage d'acquisition couplé à un étage mémoire, il est indispensable que la paire différentielle de l'étage mémoire soit mise hors fonctionnement au moment précis où la paire différentielle d'acquisition est mise en fonctionnement. S'il en était différemment, le circuit présenterait des instabilités. Or cette condition est souvent très difficile à remplir, particulièrement lorsque l'étage d'acquisition et l'étage mémoire sont commandés par des signaux d'horloge différents.

Cet inconvénient est évité du fait que l'étage mémoire et l'étage d'acquisition sont commandés par un même signal de contrôle, le signal d'horloge C.

Les grilles 2 et 1 des transistors 32 et 31, reçoivent, couplés en croix, les drains des transistors 31 et 51, et 32 et 52 respectivement. Les grilles des transistors 32 et 31 reçoivent en outre, par l'intermédiaire des résistances de couplage respectives $R_2$ et $R_1$ les signaux issus de l'étage d'acquisition.

Les points de connexion 2 et 1 constituent la sortie de cet ensemble étage d'acquisition-étage mémoire.

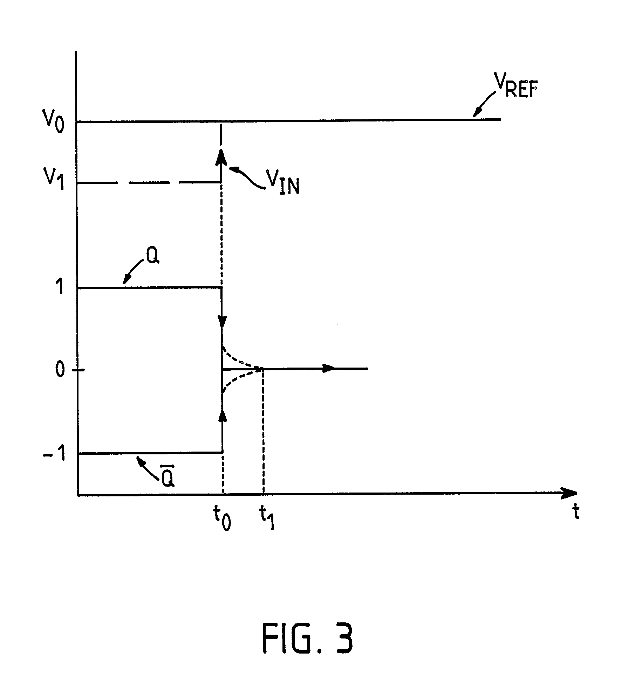

Lors d'une transition représentée sur la figure 3, pendant laquelle, le signal de référence $V_{REF}$ en trait plein étant constant, le signal d'entrée $V_{IN}$ en trait discontinu passe rapidement du niveau $V_1$ au niveau V , au temps $t_0$, les signaux Q et $\overline{Q}$ présents aux noeuds 1 et 2 devraient passer aussi rapidement de l'état 1 et -1 respectivement au même état 0.

Mais si la transition de $V_{IN}$ est abrupte alors comme il a été dit précédemment, la conductance de sortie du transistor .10, qui reçoit $V_{IN}$ devient 3 fois plus forte, à l'instant $t_0$ de la transition que la conductance de sortie du transistor 11.

Il en résulte que, si la tension drain des transistors 10 et 11 est portée directement sur l'étage mémoire comme selon l'art antérieur à travers les résistances de couplage $R_1$ et $R_2$, les signaux Q et $\overline{Q}$ aux noeuds 1 et 2 n'atteignent pas instantanément le niveau 0, mais seulement au bout d'un temps $t_1$, tel que la différence de tempos $t_0$-$t_1$ est non négligeable.

A l'instant $t_0$ de la transition rapide, la figure 3 montre en trait petit pointillé que ce traînage pourrait atteindre 10 % de la valeur de la tension qui correspond à la différence des niveaux entre Q et $\overline{Q}$ avant la transition.

C'est pourquoi, selon l'invention, on réduit cet effet en isolant l'étage différentiel des charges dans lesquelles s'opère un gain en tension.

De cette façon, on obtient qu'il n'existe plus de gain en tension au niveau des drains des transistors 10 et 11. On limite ainsi les transitoires différentielles de tension drain-source de ces transistors et on minimise les conséquences des variations de la conductance de sortie du transistor 10 en fonction de la fréquence.

Selon l'invention ce but est atteint au moyen d'un étage cascode formé des transistors 14 et 15. Les drains des transistors 14 et 15 de l'étage cascode sont portés à la tension d'alimentation continue $V_{DD}$ à travers les résistances de charge $R_4$ et $R_3$ respectivement. Les grilles couplées de ces transistors sont portées à la masse. Leurs sources sont reliées aux noeuds 34 et 35.

Dans ces conditions, les noeuds 34 et 35 (voir la figure 1) sont affectés d'un gain différentiel en tension faible.

Cet étage différentiel muni de l'étage cascode est selon l'invention appliqué à réaliser l'étage d'acquisition d'un comparateur.

Mais cet étage différentiel muni des mêmes moyens pourrait être appliqué à d'autres circuits formant charges.

Dans le circuit comparateur décrit ici à titre d'exemple, cet étage cascode isole l'étage d'acquisition de l'étage mémoire, élargit la bande passante et augmente le gain de tout l'étage comparateur.

Si, par exemple, au moment $t_0$ d'une transition rapide, la différence de niveau entre les signaux Q et $\overline{Q}$ , aux noeuds 2 et 1 respectivement se trouve être 1V, la différence de niveau entre les signaux présents sur les noeuds 34 et 35 sera seulement de l'ordre de 0,3V.

Le fonctionnement sera encore amélioré en prévoyant, comme il est montré sur la figure 1, un étage différentiel d'acquisition formé de deux transistors bi-grilles.

Le premier transistor de la paire différentielle montre les grilles 10 et 12.

Le second transistor de la paire différentielle montre les grilles 11 et 13.

Les grilles 10 et 11 réalisent, comme il a été dit précédemment, l'opération différence entre le signal d'entrée $V_{IN}$ et le signal de référence $V_{REF}$.

Les grilles 12 et 13 constituent un sous-circuit commandé par la paire différentielle 10 et 11.

Selon l'invention, on forme une contre-réaction des sorties de l'étage différentiel, concrétisées par les drains 34 et 35, sur les entrées du sous-circuit concrétisées par les grilles hautes 12 et 13 du bi-grille.

Ainsi, les deux grilles supérieures respectivement 12 et 13, rétrobouclées sur les drains 35 et 34 de ces transistors bi-grilles stabilisent les tensions de drains intermédiaires aux points 7 et 8 de ces mêmes bi-grilles.

Dans ces conditions, les pourcentages de trainage de tension de signaux Q et $\overline{Q}$ sont réduits et passent de la valeur 10 % selon l'art antérieur à la valeur 0,6 % comme montré sur la courbe en trait continu de la figure 3.

Lorsque le circuit d'étage différentiel muni des moyens de l'invention est appliqué à la réalisation d'un étage d'acquisition pour un circuit comparateur, il permet d'accélérer la vitesse de commutation en sortie de l'étage, et donc la vitesse à laquelle le résultat de la comparaison est produit.

Ce comparateur est alors un élément particulièrement performant, et il peut lui-même être utilisé pour réaliser des convertisseurs analogiques-numériques ultra-rapides et précis.

Une troisième tension d'alimentation continue $V_B$ peut être imposée sur la grille du transistor source de courant 109, à la place du signal de contrôle C, de manière à rendre ce dernier continuellement passant (voir la figure 1). Dans ces conditions l'étage d'acquisition est continuellement en fonctionnement, et les phénomènes d'instabilité sont également évités.

Cette variante est particulièrement intéressante dans le cas où l'on désirerait limiter le comparateur au seul étage d'acquisition couplé à l'étage mémoire.

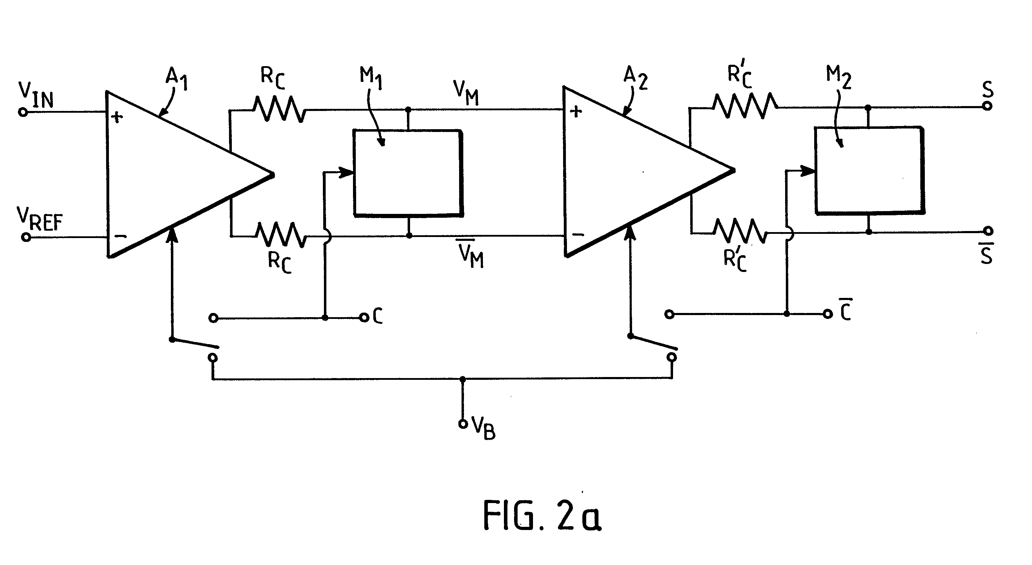

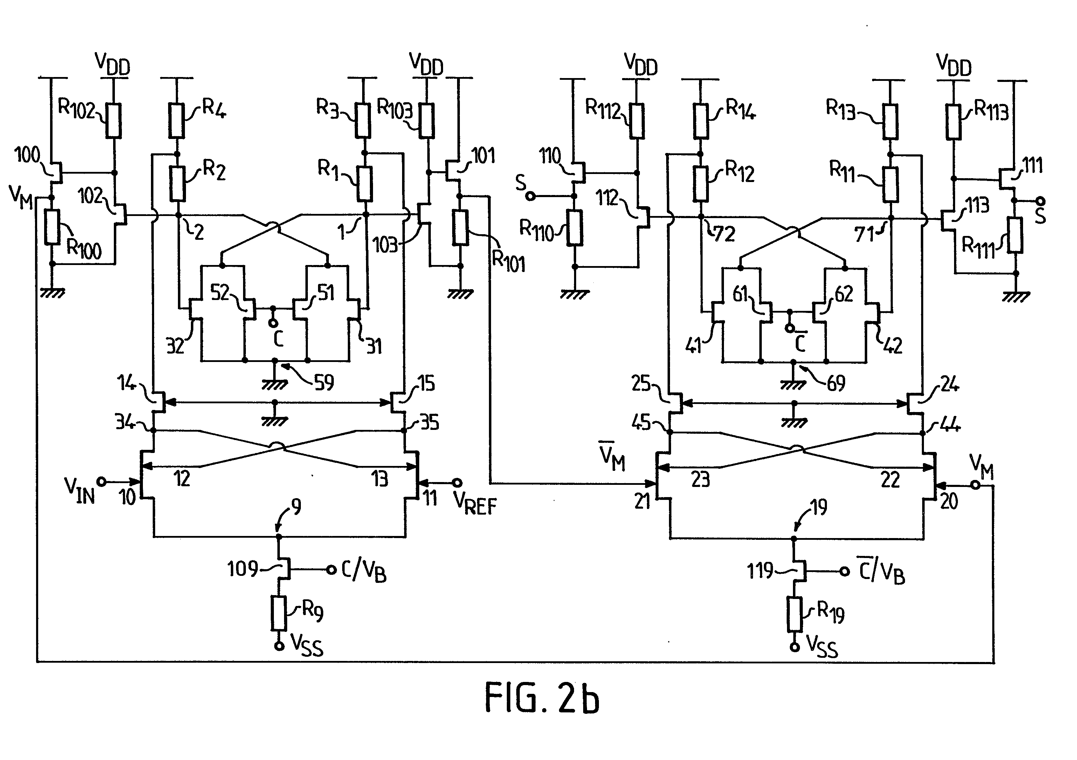

On peut encore améliorer les performances du comparateur selon l'invention en réalisant un système de deux comparateurs tels que celui qui a été décrit plus haut, groupés selon les schémas des figures 2a et 2b.

A cet effet, les noeuds 1 et 2 de sortie du premier étage comparateur précédent sont munis d'étages du signal d'horloge C.

Selon une variante, l'étage d'acquisition et l'étage amplificateur sont commandés à l'aide d'un potentiel fixe $V_B$.

Un tel système est représenté par blocs fonctionnels sur la figure 2a. L'ensemble étage amplificateur-second étage mémoire $A_2$, $M_2$ présente exactement la même structure et le même principe de fonctionnement que l'ensemble étage d'acquisition premier étage mémoire $A_1$, $M_1$. Seuls les transistors et les résistances de couplage ou de charge peuvent présenter des valeurs légèrement différentes pour une meilleure adaptation. Le schéma de cet ensemble est représenté sur la figure 26.

L'étage amplificateur $A_2$ est donc formé des deux transistors 21 et 20, couplés par les sources et dont les grilles reçoivent respectivement le signal intermédiaire $V_M$ et son complémentaire $\overline{V_M}$ disponibles sur les sources des transistors 100 et 101 des étages suivants précédemment décrits. Les sources couplées au point de connexion 19 sont reliées au drain d'un transistor source de courant 119, commandé par le signal d'horloge complémentaire $\overline{C}$, dont la source est reliée à $V_{SS}$ à travers une résistance $R_{19}$.

Le second étage mémoire $M^2$ est formé de deux transistors 41 et 42 couplés par leurs sources au point de connexion 69. Ce point de connexion est directement porté au potentiel de la masse.

La commande de cet étage mémoire est assurée par deux transistors 61 et 62 respectivement montés en parallèle sur les transistors 41 et 42, et commandés par le signal d'horloge complémentaire $\overline{C}$.

Dans ces conditions, lorsque l'étage amplificateur est mis en fonctionnement, l'étage mémoire se voit imposer directement l'état 0.

De même que précédemment, une tension d'alimentation continue $V_B$ peut être imposée sur la grille du transistor source de courant 9, 19 de manière à rendre ce dernier continuellement passant. Dans ces conditions l'étage amplificateur est continuellement en fonctionnement.

Les grilles 72 et 71 des transistors 41 et 42, reçoivent, couplés en croix les drains des transistors 42 et 62, et 41 et 61 respectivement. Les grilles des transistors 41 et 42 reçoivent en outre, par l'intermédiaire des résistances de couplage respectives $R_{12}$ et $R_{11}$ les signaux issus de l'étage amplificateur $A_2$.

Les points de connexion 71 et 72 constituent la sortie de cet ensemble étage amplificateur-second étage mémoire.

Pour isoler l'étage amplificateur de l'étage mémoire du second comparateur, on peut comme dans le premier comparateur, prévoir un étage cascode formé des transistors 25 et 24 dont les sources couplées sont portées à la masse, dont les drains sont reliés à $R_{12}$ et $R_{11}$, dont les sources sont reliées aux drains des transistors de la paire différentielle de l'étage amplificateur.

De plus, on peut prévoir, comme dans le premier comparateur que les transistors de la paire différentielle de l'étage amplificateur sont des transistors bi-grilles dont les grilles basses 20 et 21 reçoivent les signaux $V_M$ et $\overline{V_M}$ et dont les grilles hautes 22 et 23 sont reliées en croix au drain du transistor opposé, de cette paire.

On peut prévoir aussi que sur les noeuds 71 et 72 sont placés respectivement des petits étages inverseurs-suiveurs. En particulier sur le point de connexion 72 l'étage inverseur est formé du transistor 112 et de la résistance de charge $R_{112}$ et l'étage suiveur est formé du transistor 110 et de la résistance $R_{110}$.

De même pour le point de connexion 71, l'étage inverseur est formé du transistor 113 et de la résistance $R_{113}$, et l'étage suiveur, du transistor 111 et de la résistance $R_{111}$.

Le signal numérique de sortie du comparateur est disponible sur la source du transistor suiveur 111, et son complémentaire $\overline{S}$ est disponible sur la source du transistor suiveur 110.

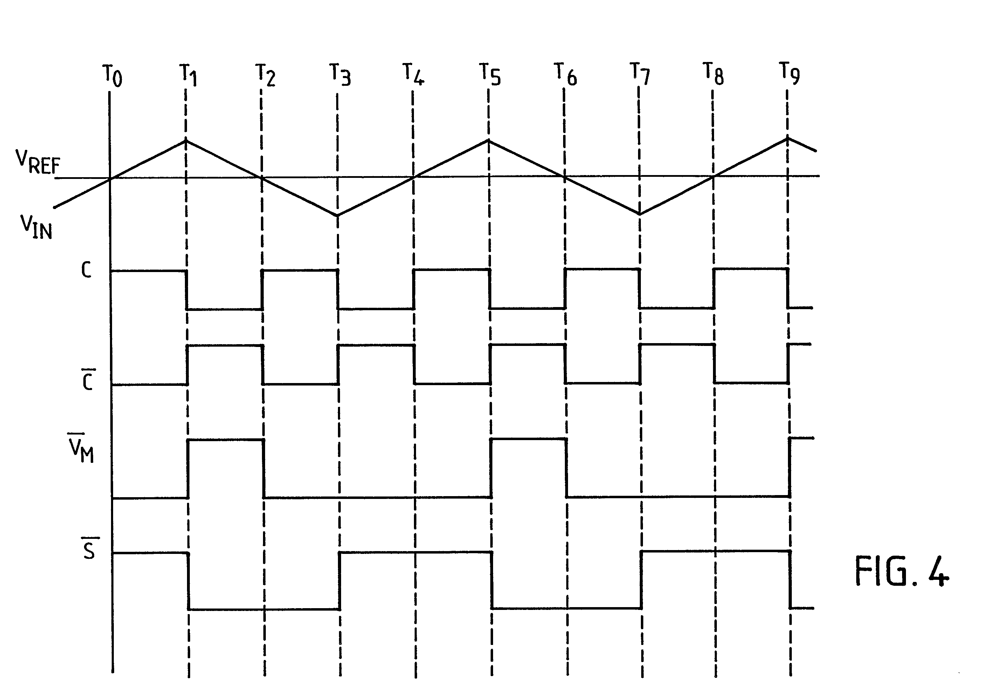

Dans ces conditions, comme il est montré sur la figure 4, lorsque la différence entre le signal d'entrée analogique $V_{IN}$ et le signal de référence analogique $V_{REF}$ appliquée sur l'étage d'acquisition est positive et qu'arrive le front descendant du signal d'horloge C au temps $T_1$, le signal complémentaire $\overline{V_M}$ par exemple est en mémorisation à l'état haut et le signal de sortie complémentaire $\overline{S}$ passe à l'état bas.

Puis lorsqu'arrive au temps $T_2$ un front montant de l'horloge C, la différence devenant négative, le signal complémentaire $\overline{V_M}$ passe en acquisition à l'état bas, et le signal de sortie complémentaire $\overline{S}$ passe en mémorisation à l'été bas.

Sur le front descendant de l'horloge, au temps $T_3$, la différence étant toujours négative, le signal intermédiaire complémentaire $\overline{V_M}$ est en mémorisation à l'état bas et le signal de sortie complémentaire $\overline{S}$ est en acquisition à l'état haut.

Enfin au temps $T_4$, la différence devenant positive sur un front de montée de l'horloge C, le signal de sortie complémentaire passe en mémorisation à l'état haut.

Ainsi le signal de sortie S suit en phase le signe de la différence entre le signal d'entrée $V_{IN}$ et le signal d référence $V_{REF}$.

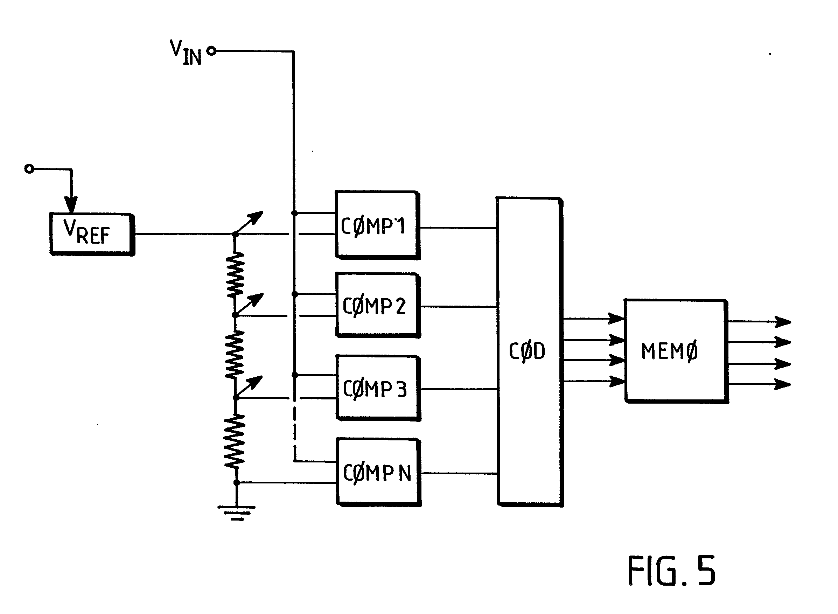

Le convertisseur analogique-numérique représenté sur la figure 5 comporte plusieurs comparateurs montés en parallèle (COMP 1,... COMPN,) qui sont munis chacun de deux entrées. La tension d'entrée analogique $V_{IN}$ à convertir est amenée à une entrée de chaque comparateur. A l'autre entrée de chaque comparateur est amenée une tension de référence obtenue par application d'une tension de référence aux bornes du montage en série de plusieurs résistances. Dans le cas où toutes les résistances sont égales, on obtient une progression arithmétique des tensions de référence, le rapport relatif des tensions de référence étant égal à $V_{REF}/2$. Les diverses tensions de référence présentant un numéro de rang 1, 2,..., i, $2^{n-1}$, $2^n$ constituent alors une série suivante $V_{REF}/2^n$, $V_{REF}/2^{n-i}$, ... $V_{REF}n$ ces dernières tensions n'étant utilisées que pour indiquer un bit de dépassement. Les sorties des comparateurs sont connectées aux entrées d'un dispositif de codage logique (COD), qui délivre un signal numérique de n bits à la sortie suivant un code quelconque, qui peut être par exemple le code de Gray. La structure du dispositif de codage est tributaire du code requis, mais n'est pas ici décrite en détail, du fait que ce dispositif de codage ne fait pas, à proprement dit, partie de l'invention. Une mémoire (MEMO) peut être couplée à la sortie du dispositif de codage pour conserver l'information du dispositif de codage pendant au moins une partie de la période d'horloge permettant la synchronisation des comparateurs. Le signal d'horloge nécessaire pour le comparateur et les mémoires est délivré par un circuit externe. Ces circuits peuvent être intégrés sur le même substrat semi-conducteur.

Dans le cas où le comparateur décrit, est réalisé à l'aide de transistors en arséniure de gallium, à grille Schottky, les tensions $V_{IN}$, $V_{REF}$, $V_M$, $\overline{V_M}$, S et S sont de 0,7 V pour le niveau haut et 0,1 V pour le niveau bas.

Les tensions de seuil des transistors sont $V_T = 0,1$ V.

Les tensions d'alimentation continues sont :

pour la première $V_{DD} = 2$ V

pour la seconde $V_B = -2,5$ V éventuellement.

pour la troisième $V_{SS} = -3$ V

Les caractéristiques des largeurs de grille L et des valeurs des résistances R sont rassemblées dans le tableau suivant :

TABLEAU I

| Transistors | | | Résistances | | |
|---|---|---|---|---|---|
| N° | $l$ en $\mu m$ | Lg | N° | R | |
| 10,12 | 50 $\mu m$ | 0,7 | $R_4$, $R_3$ | 2,7 | $k\Omega$ |
| 11,13 | 50 $\mu m$ | 1 | | | |
| 32,31 | 20 $\mu m$ | 0,7 | $R_2$, $R_1$ | 2,7 | $k\Omega$ |
| 52,51 | 20 $\mu m$ | 0,7 | $R_{102}$, $R_{103}$ | 7 | $k\Omega$ |
| 14,15 | 20 $\mu m$ | 0,7 | | | |
| 102,112 | 10 $\mu m$ | | $R_{100}$, $R_{101}$ | 3 | $k\Omega$ |
| 100,110 | 30 $\mu m$ | | | | |
| 13 | 30 $\mu m$ | | | | |
| 21,23 | 25 $\mu m$ | 1 | | | |
| 22,20 | 25 $\mu m$ | 0,7 | $R_{14}$, $R_{13}$ | 1,6 | $k\Omega$ |
| 41,42 | 20 $\mu m$ | 0,7 | $R_{12}$, $R_{11}$ | 1,6 | $k\Omega$ |
| 61,62 | 20 $\mu m$ | 0,7 | $R_{112}$, $R_{113}$ | 7 | $k\Omega$ |
| 24,25 | 20 $\mu m$ | 0,7 | | | |
| 122,132 | 10 $\mu m$ | | $R_{110}$, $R_{111}$ | 3 | $k\Omega$ |
| 130,120 | 30 $\mu m$ | | | | |
| 23 | 30 $\mu m$ | | | | |

L'utilisation d'un comparateur identique pour la réalisation d'un convertisseur analogique-numérique signifie également un avantage pour la réalisation sous forme d'un circuit intégré.

Il est évident pour l'homme de l'art que de nombreuses variantes peuvent être réalisées sans sortir du cadre de la présente invention comme défini dans les revendications ci-annexées.

## Revendications

1. Circuit semiconducteur intégré comprenant une paire différentielle de transistors à effet de champ qui sont respectivement couplés à une tension d'alimentation à travers une charge, le noeud entre chaque transistor à effet de champ et sa charge respective étant couplé à un sous-circuit pour contrôler ledit sous-circuit, caractérisé en ce qu'il comprend des moyens de lissage pour lisser les fluctuations de l'impédance de sortie de ladite partie différentielle durant la commutation.

2. Circuit intégré selon la revendication 1, caractérisé en ce que les moyens de lissage comprennent, entre chacun desdits transistors à effet de champ et sa charge respective, un transistor monté en cascode polarisé à une tension prédéterminée, le noeud entre chaque transistor monté en cascode et la charge associée étant couplé avec le sous-circuit.

3. Circuit intégré selon l'une des revendications 1 ou 2, caractérisé en ce que les moyens de lissage comprennent un moyen de contre-réaction contrôlant chacun des transistors à effet de champ de la paire différentielle au moyen d'un signal fonction de la tension entre les électrodes de l'autre transistor à effet de champ de la paire différentielle.

4. Circuit intégré selon la revendication 3, caractérisé en ce que chaque transistor à effet de champ de la paire différentielle de transistors a une première électrode de grille et une seconde électrode de grille pour recevoir un signal d'entrée, et pour la connexion à l'autre transistor à effet de champ respectivement.

5. Convertisseur analogique-numérique comprenant au moins un circuit intégré selon l'une des revendications 1, 2, 3, ou 4, dans lequel ledit sous-circuit comprend un circuit de mémoire bistable synchronisé.

FIG. 1

FIG. 2a

FIG. 2b

3-VI-PHF 88-553

FIG. 3

FIG. 4

FIG.5

EP 0 349 028 A2